# EUROPEAN PATENT SPECIFICATION

(11) **EP 3 416 002 B1**
(45) Date of publication and mention of the grant of the patent: **25.09.2024**
(21) Application number: 18156818.9
(22) Date of filing: 14.02.2018
(51) Int. Cl.: G05B 15/02, G05B 19/042

(54) **POWER AMOUNT MANAGEMENT SYSTEM, POWER AMOUNT MONITOR RECOGNITION PROGRAM, AND RECORDING MEDIUM**
STROMMENGENVERWALTUNGSSYSTEM, STROMMENGENMONITORERKENNUNGSPROGRAMM UND AUFZEICHNUNGSMEDIUM
SYSTÈME DE GESTION DE LA QUANTITÉ DE PUISSANCE, PROGRAMME DE RECONNAISSANCE DE MONITEUR DE QUANTITÉ DE PUISSANCE ET SUPPORT D'ENREGISTREMENT

(30) Priority: 13.06.2017 JP 2017116014
(43) Date of publication of application: 19.12.2018
(73) Proprietor: OMRON CORPORATION, Kyoto-shi, Kyoto 600-8530 (JP)
(72) Inventor: KAWAKAMI, Goro, KYOTO, 600-8530 (JP); MURATA, Takuya, KYOTO, 600-8530 (JP); CHIMURA, Kohei, KYOTO, 600-8530 (JP); IKEMOTO, Satoru, KYOTO, 600-8530 (JP); IURA, Shinichiro, KYOTO, 600-8530 (JP); MOTOUJI, Satoshi, KYOTO, 600-8530 (JP)
(74) Representative: 2K Patentanwälte Blasberg Kewitz & Reichel

(56) References cited:
- WO-A1-2016/003311
- US-A1- 2016 351 045

## Description

### BACKGROUND

### Technical Field

The present invention relates to a power (amount) management system that includes a plurality of power (amount) monitors and a management device that is connected to the respective power (amount) monitors for communication, a power (amount) monitor recognition program, and a recording medium storing the recognition program.

### Description of Related Art

In recent years, energy saving for reducing power consumption (energy consumption) for various electric devices that are used in companies or during production has advanced in the companies, factories, and the like. Therefore, there is a requirement for the companies, the factories, and the like themselves to ascertain how much power has been consumed.

In order to achieve such an object, various devices and systems that display transition of power consumption and current total power consumption (the total amount of power used) in the respective companies, factories, and the like have been proposed.

For example, JP 2014-23280 A discloses an energy use amount monitor device that is used in an energy measurement system that includes a plurality of measurement units. The energy use amount monitor device includes a communication interface for communication, an input device, and a personal computer that displays a setting screen that reflects an input through the input device. In addition, a CPU of a personal computer executes group setting processing of linking the plurality of measurement units with arbitrary groups and display processing of displaying the linked respective groups with the amount of used energy in the groups.

WO 2016/003311 A1 discloses a method comprising discovering, by a client device in a wireless network, an availability of a new device to be set up for connection to the Cloud via the wireless network, and determining an access point basic service set or creating an independent basis service set as an entry point to enable the new device to join the wireless network over a wireless link. Further, the method involves establishing a secure communication session over the wireless link, and sending, from the client device to the new device, information including wireless network credentials and registration information needed to set up the new device for connection to the Cloud via the wireless network.

### SUMMARY

In the energy use amount monitor device in the related art, it is necessary to cause the personal computer to recognize the plurality of measurement units as an assumption for performing the group setting processing of linking the plurality of measurement units to the arbitrary groups.

In the related art, individual management numbers are set for the plurality of measurement units, and the personal computer is made to recognize the measurement units with the management numbers in a case of causing the personal computer to recognize the plurality of measurement units.

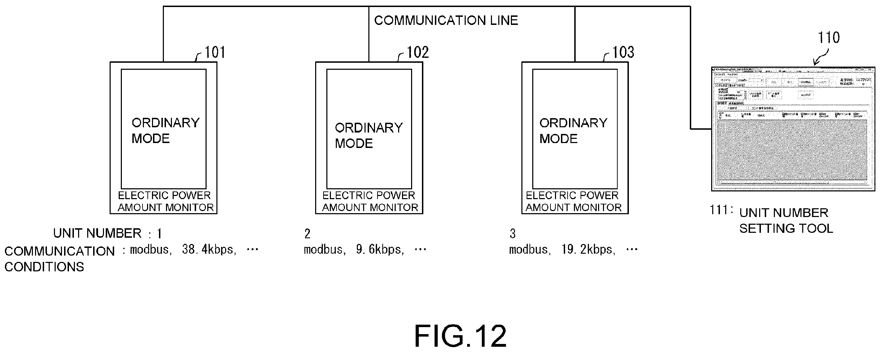

Specifically, individual management numbers are set first for the respective measurement units 101, 102, and 103 as illustrated in FIG. 12 in order to cause the personal computer to recognize the measurement units with the management numbers. In addition, it is necessary for setting software 111 of a personal computer 110 to write the management numbers in the measurement units 101, 102, and 103 and to record communication conditions (protocols, communication speeds, and the like) set for the measurement units 101, 102, and 103. The setting is individually manually performed.

However, there is a problem that a large number of processes are required for causing the management device such as a personal computer to recognize measurement units in a case in which there are multiple measurement units, such as fifty measurement units.

The present invention was made in view of the aforementioned problem in the related art, and an object thereof is to provide a power (amount) management system, a power (amount) monitor recognition program, and a recording medium capable of reducing a time required for the operation of recognizing the respective power mount monitors by the management device in the case in which multiple power (amount) monitors are present.

In particular, the aforementioned problem is solved by a power management system according to claim 1. According to the present invention, there is provided a power (amount) management system including: a plurality of power (amount) monitors; and a management device that is connected to the respective power (amount) monitors for communication, in which the respective power (amount) monitors include a first mode in which at least the power (amount) value is transmitted under individual communication conditions, wherein the communication conditions at least include a communication rate, and a second mode in which the management device is made to recognize the respective power (amount) monitors. The management device includes a control unit that is adapted to transmit commands for causing the respective power (amount) monitors to transition from the first mode to the second mode by using all combinations of possible communication conditions of the respective power (amount) monitors, wherein a manufacturing management identifier is an identifier that is applied to the power (amount) monitors when the power monitor is manufactured, and the identifier is inputted in the management device by a user in order to select the desired power (amount) monitor. The second mode is a communication mode wherein the communication is performed under common communication conditions, that is, under fixed communication conditions for the power (amount) monitors, so as to omit to individually communicate with the plurality of power (amount) monitors by using the individual communication conditions. Note that the manufacturing management identifier is a management identifier such as a manufacturing number or a manufacturing symbol specific to a product that is applied when the product is manufactured.

According to the present invention, the power (amount) management system includes the plurality of power (amount) monitors and the management device that is connected to the respective power (amount) monitors for communication.

In this type of power (amount) management system, it is necessary to cause the management device to recognize the respective power (amount) monitors as an initial setting. In the recognizing operation, the individual manufacturing management identifiers, such as management numbers, are set for the respective power (amount) monitors, and the management device is made to recognize the power (amount) monitors with the manufacturing management identifiers in the related art. In addition, in order to cause the management device to recognize the power (amount) monitors with the manufacturing management identifiers, it is necessary to write the manufacturing management identifiers in the management device and record the individual communication conditions set for the power (amount) monitors with the manufacturing management identifiers. The setting is individually and manually performed.

However, there is a problem that a large number of processes are required for causing the management device to recognize the all the power (amount) monitors in a case in which there are multiple power (amount) monitors.

Thus, in the power (amount) management system according to the present invention, the respective power (amount) monitors include a first mode in which at least the power (amount) value is transmitted under individual communication conditions and a second mode in which the management device is made to recognize the respective power (amount) monitors, and the management device includes a control unit that transmits commands for causing the respective power (amount) monitors to transition from the first mode to the second mode by using all combinations of possible communication conditions of the respective power (amount) monitors, selects a desired power (amount) monitor by using a manufacturing management identifier set in advance for each of the power (amount) monitors, and communicates with the selected power (amount) monitor.

As a result, according to the present invention, the management device transmits the commands for causing the respective power (amount) monitors to transition from the first mode to the second mode by using the all combinations of possible communication conditions of the respective power (amount) monitors first. That is, the management device does not know what kind of communication conditions the respective power (amount) monitors have in an initial stage. However, since the types of the communication conditions of all the power (amount) monitors are limited, it is possible to perform communication between the respective power (amount) monitors by transmitting commands to the power (amount) monitors by using the all combinations of possible communication conditions of the respective power (amount) monitors.

However, the management device cannot recognize a specific power (amount) monitor in this state. Thus, according to the present invention, the control unit selects a desired power (amount) monitor by using a manufacturing management identifier set for each power (amount) monitor in advance and communicates with the selected power (amount) monitor. That is, the respective power (amount) monitors have manufacturing management identifiers, such as manufacturing numbers, as individual identification information items, and the manufacturing management identifiers are registered in the power (amount) monitors in advance. Therefore, the control unit of the management device selects the desired power (amount) monitor by using the manufacturing management identifier set for each power (amount) monitor. In this manner, the selected power (amount) monitor can transmit the communication conditions or the like to the management device, and thereafter, communication can be performed between the selected power (amount) monitor and the management device. Note that the manufacturing management identifiers are typically sequential numbers, and the management device can easily select the power (amount) monitors with the manufacturing management identifiers in a range by designating the range of the manufacturing management identifiers for searching.

This means that it is possible to easily and individually perform the communication between the power (amount) monitors and the management device in a short time by using the manufacturing management identifiers set for the respective power (amount) monitors without manual recognition operations based on management numbers, which have been performed in the related art.

Incidentally, although the respective power (amount) monitors transmit at least the power (amounts) values under individual communication conditions in the first mode, the respective power (amount) monitors and the management device perform communication by using the manufacturing management identifiers set for the respective power (amount) monitors in a special case. Thus, the respective power (amount) monitors preferably have the second mode for causing the management device to recognize the respective power (amount) monitors as a mode different from the first mode, and the respective power (amount) monitors and the management device perform communication by using the manufacturing management identifiers in the second mode.

As a result, according to an aspect of the present invention, it is possible to provide a power (amount) management system capable of shortening a time required for the recognition operations of the respective power (amount) monitors by the management device in a case in which there are multiple power (amount) monitors.

In the power (amount) management system according to the present invention, the control unit communicates with the power (amount) monitors under common communication conditions in a case in which the power (amount) monitors are in the second mode.

That is, the power (amount) monitor transmits at least power (amounts) values under individual communication conditions in the first mode and transmits the power (amounts) values to the power (amount) monitors under the common communication conditions. Therefore, since it is possible to omit time and effort for individually communicating with the plurality of power (amount) monitors by using the individual communication conditions, the management device can communicate with the respective power (amount) monitors in a short time.

In the power (amount) management system according to an aspect of the present invention, the control unit preferably selects the desired power (amount) monitor by using a model code of the power (amount) in addition to the manufacturing management identifier.

In this manner, it is possible to employ the plurality of power (amount) monitors of different models.

Meanwhile, sequential numbers are given as the manufacturing management identifiers of the power (amount) monitors for each of the models of the power (amount) monitors in many cases. Therefore, there is a possibility that a plurality of power (amount) monitors of different models with the same manufacturing management identifiers cannot be identified in the selection of the power (amount) monitors using only the manufacturing management identifiers of the power (amount) monitors.

Thus, according to an aspect of the present invention, the control unit selects the desired power (amount) monitor by using the model code of the power (amount) monitor in addition to the manufacturing management identifier. In this manner, it is possible to identify the plurality of power (amount) monitors of different models with the same manufacturing management identifiers.

Note that it is also possible to use either official models themselves or abbreviations of the models by using the model codes. Use of the abbreviations has an advantage that it is possible to simplify the model as compared with the use of official models.

In the power (amount) management system according to an aspect of the present invention, each manufacturing management identifier includes a code that represents a manufacturing year and a manufacturing month and a sequence number of the power (amount) monitor, and the control unit selects the corresponding power (amount) monitor and causes the power (amount) monitor to perform display by designating the model code, the manufacturing year, the manufacturing month, and the sequence number of the power (amount) monitor.

That is, each manufacturing management identifier includes the code that represents a manufacturing year and a manufacturing month and the sequence number of the power (amount) monitor in some cases. In such cases, if the management device is to select a power (amount) monitor by using the manufacturing management identifier and there are a large number of power (amount) monitors, it may not be possible to identify the respective power (amount) monitors unless all the manufacturing management identifiers are input. However, if there are a small number of power (amount) monitors, it may be possible to select the power (amount) monitor by selecting only the manufacturing year of the power (amount) monitor or a combination of the manufacturing year and the manufacturing month by a search condition in some cases.

As a result, it is possible to select the desired power (amount) monitor in a short time in the case in which there are a small number of power (amount) monitors.

In the power (amount) management system according to an aspect of the present invention, the control unit preferably applies a management number to the selected power (amount) monitor.

In this manner, the management device can manage the power (amount) monitor by using a management number, which has been used in the related art, for the identified power (amount) monitor since the management number is applied to the selected power (amount) monitor. Note that it is possible to automatically apply a sequential number or the like as the management number while displaying the selected power (amount) monitor on a list, for example, and to thereby easily apply the management number to the power (amount) monitor.

In the power (amount) management system according to an aspect of the present invention, the control unit preferably turns on a lamp for the selected power (amount) monitor.

In this manner, since lamps for a plurality of selected power (amount) monitors are turned on, it is possible to check which of the power (amount) monitors have been selected.

In the power (amount) management system according to an aspect of the present invention, the control unit is preferably able to set at least a part of setting items for the power (amount) monitor.

In this manner, it is possible to set at least a part of setting items for a specific power (amount) monitor after the specific power (amount) monitor is able to be identified. Therefore, it is possible to provide a convenient power (amount) management system.

In the power (amount) management system according to an aspect of the present invention, the control unit is preferably able to transmit commands for causing the power (amount) monitors to transition from the second mode to the first mode.

In this manner, the respective power (amount) monitors can receive the commands for transitioning from the second mode to the first mode from the management device and then transmit at least the power (amounts) values in the first mode under individual communication conditions. In addition, if the manage number has already been set in this case, each power (amount) monitor can transmit at least the power (amount) value to the management device or the like by using the management number under the individual conditions in a manner similar to that in the related art.

According to an aspect of the present invention, an effect that a power (amount) management system capable of shortening a time required for recognition operations of the respective power (amount) monitors by a management device in a case in which there are a large number of power (amount) monitors are provided is exhibited.

### BRIEF DESCRIPTION OF THE DRAWINGS

FIG. 1 is a block diagram illustrating an embodiment of a power (amount) management system according to the present invention and illustrating a configuration of the power (amount) management system.
FIG. 2 is a diagram schematically illustrating an overall configuration of the power (amount) management system.
FIG. 3 is a front view illustrating an external configuration of a power (amount) monitor that is included in the power (amount) management system.
FIG. 4 is a block diagram illustrating a configuration of a control system of the power (amount) monitor.
FIG. 5A is a diagram schematically illustrating an operation of causing the power (amount) monitor to transition from an ordinary mode to a setting mode in a personal computer of the power (amount) management system, and FIG. 5B is a partial enlarged view illustrating a software screen of the personal computer.
FIG. 6 is a flowchart illustrating an operation of causing the power (amount) monitor to transition from the ordinary mode to the setting mode in the personal computer of the power (amount) management system.
FIG. 7 is an enlarged view illustrating a software screen when an operation of searching for manufacturing numbers of power (amount) monitors is performed in the personal computer of the power (amount) management system.
FIG. 8A, FIG. 8B, and FIG. 8C are diagrams illustrating a method of searching for manufacturing numbers of the power (amount) monitors and listing the located power (amount) monitors in the personal computer of the power (amount) management system.
FIG. 9 is a flowchart illustrating a method of searching for the manufacturing numbers of the power (amount) monitors in the personal computer of the power (amount) management system.
FIG. 10 is an enlarged view illustrating an operation of assigning unit numbers to the respective power (amount) monitors in the personal computer of the power (amount) management system and illustrating a software screen of the personal computer.
FIG. 11A is a diagram schematically illustrating an operation of causing the power (amount) monitor to transition from the setting mode to the ordinary mode in the personal computer of the power (amount) management system, and FIG. 11B is a partial enlarged view illustrating the software screen of the personal computer.
FIG. 12 is a diagram schematically illustrating an operation of assigning unit numbers in a power (amount) management system in the related art.

### DESCRIPTION OF THE EMBODIMENTS

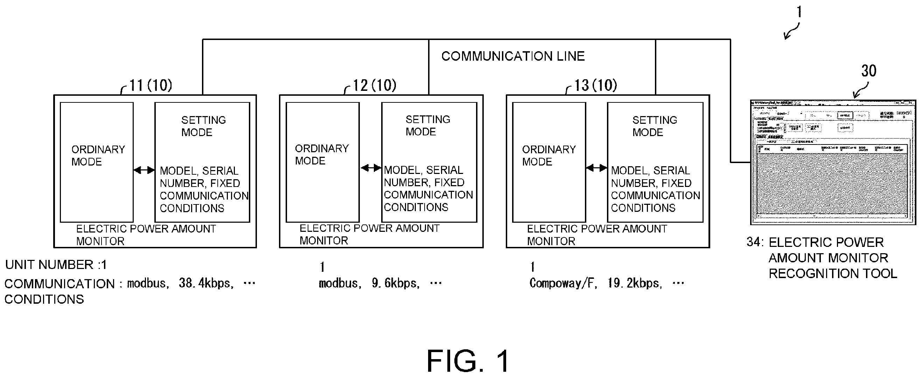

An embodiment of the present invention will be described below with reference to FIG. 1 to FIG. 11B.

### (Overall configuration of power (amount) management system)

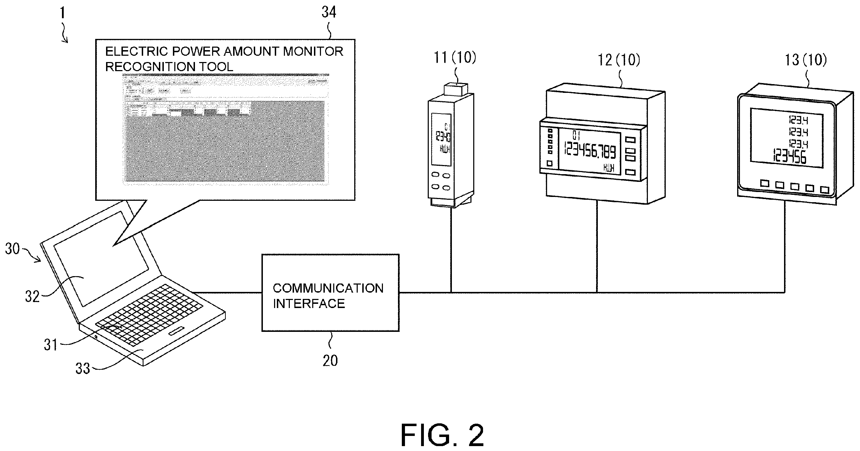

A configuration of a power (amount) management system 1 according to the embodiment will be described with reference to FIG. 2. FIG. 2 is a diagram schematically illustrating an overall configuration of the power (amount) management system 1 according to the embodiment.

As illustrated in FIG. 2, the power (amount) management system 1 according to the embodiment includes a plurality of power (amount) monitors 11, 12, 13 and a personal computer 30 that is connected to the respective power (amount) monitors 11, 12, 13 through communication and that serves as a management device (hereinafter referred to as a "personal computer 30"). A communication interface 20 is connected between the personal computer 30 and the respective power (amount) monitors 11, 12, 13 such that the personal computer 30 and the respective power (amount) monitors 11, 12, 13 communicate with each other via the communication interface 20.

RS-485 terminals are provided in the respective power (amount) monitors 11, 12, 13, for example, and USB terminals are provided in the personal computer 30. Therefore, the communication interface 20 includes a USB/RS-485 converter, for example. Note that the communication interface 20 is not necessarily limited thereto and may be another communication interface.

The description will be given on the assumption that the power monitors 11, 12, 13 of three different models are provided as illustrated in FIG. 2 in the embodiment for simple description. However, the number of the power (amount) monitors is not limited to three, and more power (amount) monitors, for example, 10 to 100 power (amount) monitors, are assumed. In this manner, it is possible to obtain a high effect in recognition operations of the power (amount) monitors.

Here, all the power (amount) monitors 11, 12, 13 may be of the same model, or different numbers of power (amount) monitors of different models may be provided. In addition, although the power (amount) monitors 11, 12, 13 are described with different member numbers in the embodiment, the power (amount) monitors 11, 12, 13 may be referred to as "power (amount) monitors 10" in a case in which the description applies to any of the power (amount) monitors 11, 12, 13. That is, although the power (amount) monitors 11, 12, 13 in the embodiment are of different models and have different functions, the power (amount) monitors 11, 12, 13 are common in that the power (amount) monitors 11, 12, 13 transmit at least power (amounts) values.

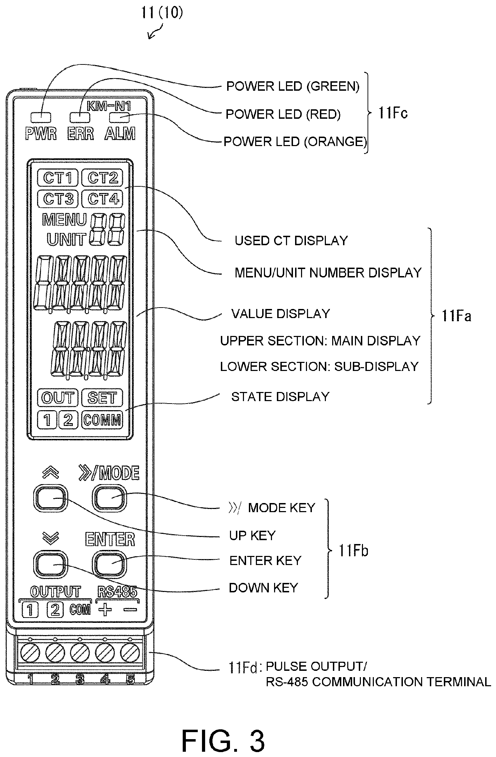

An external configuration of the power (amount) monitor 11 that is one of the power (amount) monitors 10 will be described with reference to FIG. 3. FIG. 3 is a front view illustrating an external configuration of the power (amount) monitor 11 according to the embodiment.

As illustrated in FIG. 3, the power (amount) monitors 10 according to the embodiment detect currents (alternative currents) that flow through electric power lines in equipment such as a house or a plant and voltages (alternative voltages) that are applied to the electric lines and compute various electric variables such as power (amounts) values on the basis of the detected current and the voltage. The power (amount) monitor 11 according to the embodiment can perform measurement on a maximum of four electric power lines, for example.

A display unit 11Fa, a plurality of operation buttons 11Fb, a display lamp 11Fc, and a communication terminal 11Fd is provided on a front surface of the power (amount) monitor 11.

The display unit 11Fa displays measurement values of the electric variables and other kinds of information. The display unit 11Fa includes a display element such as a segment-type liquid crystal display (LCD) or a dot matrix-type LCD. In the example illustrated in FIG. 3, a segment-type LCD is used.

The display unit 11Fa can perform used CT display, menu/unit number display, display of various values such as used power (amounts) values, state display, and the like.

The operation buttons 11Fb are button switches for allowing a user to input operations. Specifically, a MODE key for switching a circuit to be displayed, an up-down key, an enter key, and the like are provided. For example, long press of the mode key leads to shift to a mode setting mode. Then, a mode is selected with the up-down key, and the mode is set with the enter key.

As the display lamp 11Fc, display lamps such as a power LED (green), an error LED (red), and an alarm (orange) are provided. In the embodiment, an alarm LED (orange), for example, of the selected power (amount) monitor is turned on in a case in which the personal computer 30 has selected the predetermined power (amount) monitor in the setting mode as will be described later.

The communication terminals 11Fd are pulse output/RS-485 communication terminals, for example.

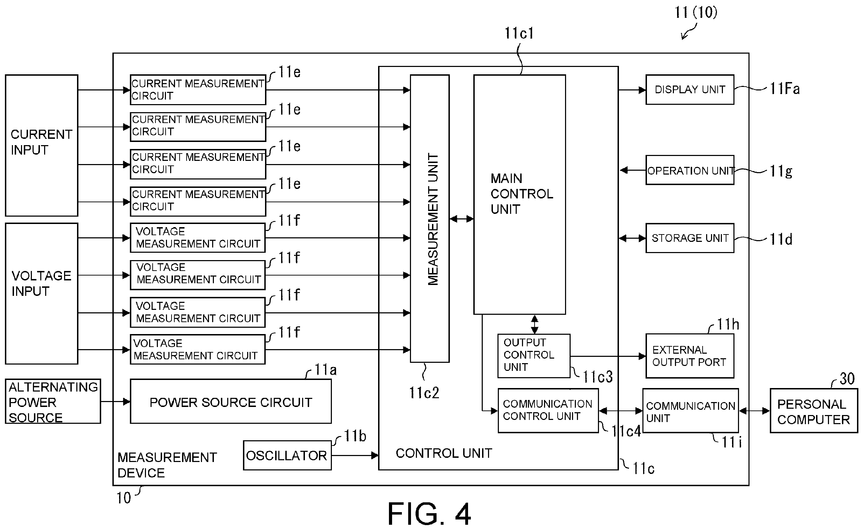

Next, a control system of the power (amount) monitor 11 will be described with reference to FIG. 4. FIG. 4 is a block diagram illustrating a configuration of the control system of the power (amount) monitor 11 according to the embodiment. Note that control systems of the power (amount) monitors 12 and 13 also have similar structures.

As illustrated in FIG. 4, the power (amount) monitor 11 includes a power source circuit 11a, an oscillator 11b, a control unit 11c, a storage unit 11d, a plurality of (four in the example in the drawing) current measurement circuits 1 1e, a plurality of (four in the example in the drawing) voltage measurement circuits 11f, an operation unit 11g, the aforementioned display unit 11Fa, an external output port 11h, and a communication unit 11i.

The power source circuit 11a is a power source that drives the respective parts in the power (amount) monitor 11. Specifically, the power source circuit 11a converts an alternating voltage input from an external alternating power source into a direct voltage in accordance with operations of the respective parts in the power (amount) monitor 11 and outputs the direct voltage to the respective parts in the power (amount) monitor 11.

The oscillator 1 1b is a clock source of the control unit 11c. Examples of the oscillator 11b includes a ceramic oscillator, a quartz oscillator, and the like.

The control unit 11c collectively controls operations of various configurations in the power (amount) monitor 11 and includes a computer including a central processing unit (CPU) and a memory, for example. In addition, the operations of the various configurations are controlled by causing the computer to execute a control program.

The storage unit 11d records information and includes a recording device such as a hard disk or a flash memory.

The current measurement circuits 11e convert a current input from an external current transformer or the like into a voltage that can be measured by the control unit 11c and outputs the voltage to the control unit 11c. The current measurement circuits 11e may be known current and voltage conversion circuits (for example, I/V amplifier circuits) that are realized by using operation amplifiers.

The voltage measurement circuits 11f converts a voltage input from the outside into a voltage that can be measured by the control unit 11c and outputs the voltage to the control unit 11c. The voltage measurement circuits 11f may be realized by known voltage detection integrated circuits (IC).

The operation unit 11g receives various inputs from the user by user's operations and includes the aforementioned operation buttons 11Fb, a dip switch, other operation devices, and the like. The operation unit 11g converts information operated by the user into operation data and transmits the information to the control unit 11c.

The external output port 11h outputs, as pulses, measurement values of the electric variables (for example, integrated power (amounts) values) measured by the control unit 11c to an external device, which is not illustrated in the drawing.

The communication unit 11i communicates data with the external personal computer 30. The communication unit 11i converts various kinds of data received from the control unit 11c into a format suitable for data communication and then transmits the various kinds of data to the personal computer 30. In addition, the communication unit 11i converts various kinds of data received from the personal computer 30 into a data format inside the device and then transmits the various kinds of data to the control unit 11c. In this manner, the communication unit 11i can transmit data such as various electric variables measured by the control unit 11c to the personal computer 30 in response to a request from the personal computer 30.

Next, details of the control unit 11c and the storage unit 11d will be described. As illustrated in FIG. 4, the control unit 11c includes a main control unit 11c1, a measurement unit 11c2, an output control unit 11c3, and a communication control unit 11c4.

The main control unit 11c1 collectively controls various blocks in the control unit 11c.

The measurement unit 11c2 performs computation processing by using voltages from the current measurement circuits 11e and voltages from the voltage measurement circuits 11f, thereby measuring various electric variables in the electric power lines. The measurement unit 11c2 stores measurement data including measurement values obtained by measuring electric variables and a date and time of the measurement in the storage unit 11d.

The output control unit 11c3 controls the external output port 11h. In addition, the communication control unit 11c4 controls the communication unit 11i.

Next, the personal computer 30 includes a keyboard 31 that is an input unit, a display unit 32, a central processing unit (CPU) 33 that is a control unit as illustrated in FIG. 2.

The CPU according to the embodiment has software that is a power (amount) monitor recognition tool 34 for recognizing the plurality of power (amount) monitors 11, 12, 13.

### (Recognition operations of plurality of power (amount) monitors in power (amount) management system)

As described above, the power (amount) management system 1 according to the embodiment includes the plurality of power (amount) monitors 11, 12, 13 and the personal computer 30 that is the management device connected to the power (amount) monitors 11, 12, 13 for communication.

It is necessary to cause the personal computer 30 to recognize the respective power (amount) monitors 11, 12, 13 as initial setting in this type of power (amount) management system 1. In the recognition operations, unit numbers that are individual management numbers are set for the respective power (amount) monitors, and also the management device is made to recognize the power (amount) monitors of the unit numbers. In addition, in order to cause the management device to recognize the power (amount) monitors of the management numbers, it is necessary to write the management numbers and to record the individual communication conditions set for the power (amount) monitors of the management numbers in the management device. The setting is individually manually performed.

However, there is a problem that a large number of processes are needed to cause the management device to recognize all the power (amount) monitors in a case in which there are multiple power (amount) monitors.

Thus, the power (amount) management system 1 according to the embodiment has the following configuration to cause the personal computer 30 to recognize all the power (amount) monitors 11, 12, 13 in the case in which there are multiple power (amount) monitors 11, 12, 13.

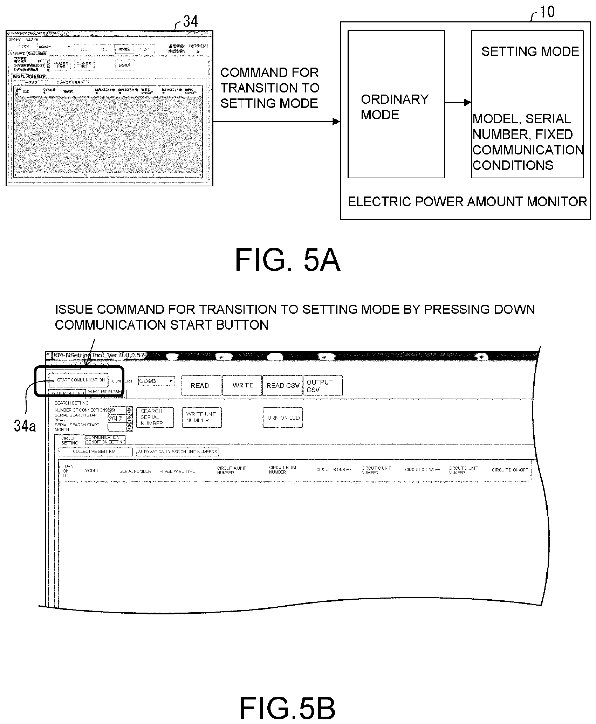

A configuration for causing the personal computer 30 to recognize all the power (amount) monitors 11, 12, 13 in the power (amount) management system 1 according to the embodiment will be described with reference to FIG. 1 and (a) and FIG. 5B. FIG. 1 is a block diagram illustrating a configuration of the power (amount) management system 1 according to the embodiment. FIG. 5A is a diagram schematically illustrating an operation of causing the power (amount) monitors 11, 12, 13 to transition from the ordinary mode to the setting mode by the personal computer 30 of the power (amount) management system 1. FIG. 5B is a partial enlarged view illustrating a software screen of the personal computer 30.

As illustrated in FIG. 1, the respective power (amount) monitors 11, 12, 13 include the ordinary mode that is the first mode in which at least the power (amounts) values are transmitted under the individual communication conditions and the setting mode that is the second mode in which the personal computer 30 is made to recognize the respective power (amount) monitors 11, 12, 13. In the ordinary mode, the power (amount) monitor 11 performs communication to transmit the power amount and the like along with the personal computer 30 and the like under a condition of 38.4 kbps, for example, as illustrated in FIG. 1. The power (amount) monitor 12 performs communication under a communication condition of 9.6 kbps, for example. The power (amount) monitor 13 performs communication under a communication condition of 19.2 kbps, for example. In this manner, the respective power (amount) monitors 11, 12, 13 transmits the power amount and the like along with the personal computer 30 and the like under the different communication conditions. This is because there is a case in which the respective power (amount) monitors 11, 12, 13 employs different communication conditions due to mutually different models. In addition, although the report destination of the power (amounts) values from the respective power (amount) monitors 11, 12, 13 is generally the personal computer 30, the report destination is not necessarily limited thereto, and there is also a case in which the power (amounts) values and the like are reported to another device in some cases.

Meanwhile, the personal computer 30 recognizes the respective power (amount) monitors 10 by the following processing in the setting mode in the embodiment.

That is, in a case in which the recognition operations of the respective power (amount) monitors 10 are performed as illustrated in (a) and FIG. 5B, the personal computer 30 transmits commands for causing the respective power (amount) monitors 10 to transition from the ordinary mode to the setting mode to the respective power (amount) monitors 10 by pressing down a communication start button 34a on the software screen of the power (amount) monitor recognition tool 34.

Here, the personal computer 30 does not recognize what kinds of communication conditions the respective power (amount) monitors 11, 12, 13 have in the initial stage. However, the types of the communication conditions of all the power (amount) monitors 11, 12, 13 are limited. Thus, the personal computer 30 transmits the commands to the power (amount) monitors 11, 12, 13 by using the all combinations of possible communication conditions for the respective power (amount) monitors 11, 12, 13 in the embodiment. In this manner, the personal computer 30 can communicate with all the respective power (amount) monitors 11, 12, 13 and cause the respective power (amount) monitors 11, 12, 13 to transition from the ordinary mode to the setting mode.

In addition, in a case in which the power (amount) monitors 10 are in the setting mode as illustrated in FIG. 5A, the communication is performed under common communication conditions, that is, under fixed communication conditions for the power (amount) monitors 10 in the embodiment. In this manner, since it is possible to omit the time and efforts to individually communicate with the plurality of power (amount) monitors 11, 12, 13 by using the individual communication conditions, the personal computer 30 can communicate with the respective power (amount) monitors 11, 12, 13 in a short time.

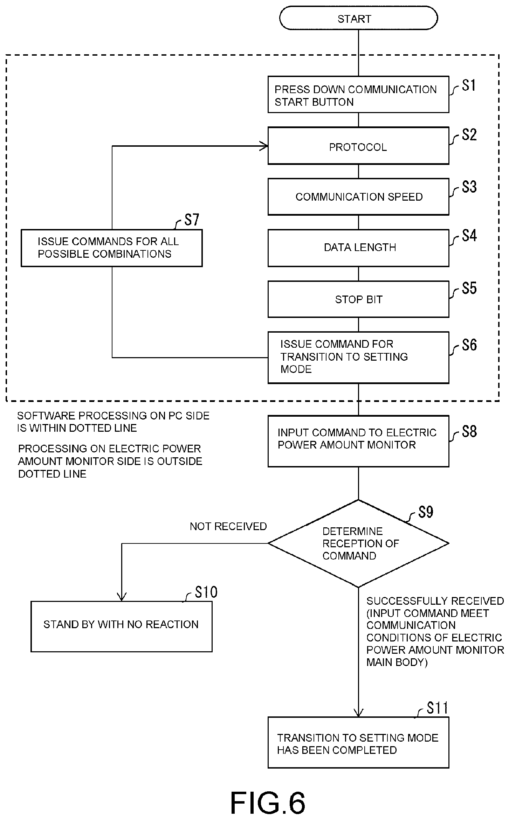

FIG. 6 is a flowchart illustrating an operation of causing the power (amount) monitors 11, 12, 13 to transition from the ordinary mode to the setting mode by the power (amount) monitor recognition tool 34 of the personal computer 30.

In a case in which the power (amount) monitors 11, 12, 13 are made to transition from the ordinary mode to the setting mode as illustrated in FIG. 6, the power (amount) monitor recognition tool 34 presses down the communication start button 34a first (S1). Then, the communication conditions that the respective power (amount) monitors 11, 12, 13 use in the communication mode are set. Since the communication conditions that the respective power (amount) monitors 11, 12, 13 uses in the ordinary mode are mutually different in the embodiment, the communication conditions are individually set (S7). Specifically, a protocol (S2), a communication speed (S3), a data length (S4), and a stop bit (S5) that are communication conditions for the power (amount) monitor 11 are set, and a setting mode transition command is issued (S6) for performing communication with the power (amount) monitor 11, for example.

If the communication with the power (amount) monitor 11 is completed, then commands for all possible combinations are issued (S7). Specifically, a protocol (S2), a communication speed (S3), a data length (S4), and a stop bit (S5) that are communication conditions for the power (amount) monitor 12 are set, and a setting mode transition command is issued (S6) for performing communication with the power (amount) monitor 12 in the embodiment.

Then, the processing returns to S7, a protocol (S2), a communication speed (S3), a data length (S4), and a stop bit (S5) that are communication conditions for the power (amount) monitor 13 are set, and a setting mode transition command is issued (S6) for performing communication with the power (amount) monitor 13.

In this manner, the commands are input to the respective power (amount) monitors 11, 12, 13 (S8). The respective power (amount) monitors 11, 12, 13 perform command reception determination (S9). In a case in which the commands are determined to have not been received in the command reception determination, the power (amount) monitors 11, 12, 13 are brought into a stand-by state with no reactions (S10).

Meanwhile, in a case in which the input commands have been received by the respective power (amount) monitors 11, 12, 13 under the communication conditions that coincide with those of the respective power (amount) monitors 11, 12, 13, the transition to the setting mode is completed (S11).

In the aforementioned state in which the respective power (amount) monitors 11, 12, 13 have been made to transition to the setting mode, specific power (amount) monitors 11, 12, 13 are selected in the embodiment.

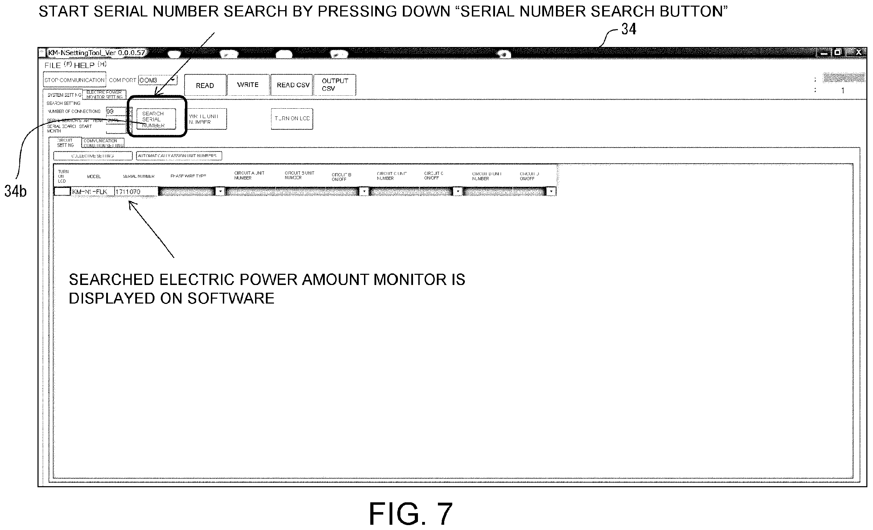

FIG. 7 is an enlarged view illustrating a software screen when the power (amount) monitor recognition tool 34 of the personal computer 30 performs operations of searching the manufacturing numbers of the power (amount) monitors.

As illustrated in FIG. 7, the power (amount) monitor recognition tool 34 presses down a serial number search button 34b to select specific power (amount) monitors 11, 12, 13 in the embodiment. In this manner, the serial numbers that are the searched manufacturing numbers as manufacturing management identifiers of the power (amount) monitors 11, 12, 13 are displayed on the power (amount) monitor recognition tool 34. Note that the manufacturing numbers are generally applied as the manufacturing management identifiers when the power (amount) monitors 10 are manufactured. Therefore, the embodiment will be described on the assumption that the manufacturing management identifiers are the manufacturing numbers. However, the manufacturing management identifiers are not necessarily limited to the manufacturing numbers and may be manufacturing codes, for example, according to an aspect of the present invention. In addition, the manufacturing management identifiers may be manufacturing management characters, for example, other than the manufacturing numbers and the manufacturing codes.

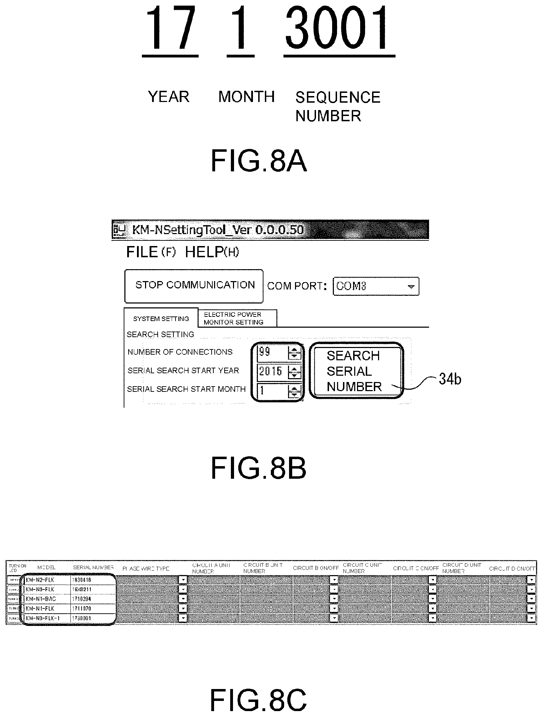

A method of searching the manufacturing numbers of the power (amount) monitors 11, 12, 13 according to the embodiment will be described in detail with reference to FIG. 8A, FIG. 8B, and FIG. 8C. FIG. 8A, FIG. 8B, and FIG. 8C are diagrams illustrating a method of searching serial numbers that are the manufacturing numbers of the power (amount) monitors 11, 12, 13 and listing the searched power (amount) monitors by the power (amount) monitor recognition tool 34 of the personal computer 30 in the power (amount) management system 1.

As illustrated in FIG. 8A, the serial numbers that are the manufacturing numbers of the power (amount) monitors 10 according to the embodiment includes codes that indicate manufacturing years of the power (amount) monitors 10 (for example, "17" indicating 2017), a codes that indicate manufacturing months (for example, "1" indicating January), and sequence numbers (for example, "3001").

Therefore, the power (amount) monitor recognition tool 34 selects the power (amount) monitors 11, 12, 13 by using the serial number "1713001" that is a manufacturing number.

Here, there is also a case in which the power (amount) monitor recognition tool 34 cannot identify the respective power (amount) monitors 10 unless the entire serial number "1713001" is input if there are a large number of power (amount) monitors 10 when the power (amount) monitors 11, 12, 13 are selected by using the serial number "1713001". However, there is a case in which the desired power (amount) monitors 10 can be selected by selecting only the manufacturing year or the combination of the manufacturing year and the manufacturing month of the power (amount) monitors 10 as a search condition in a case in which there are a small number of power (amount) monitors 10.

Thus, it is possible to search the power (amount) monitors 10 by using only the manufacturing year of the power (amount) monitors 10, only the manufacturing month of the power (amount) monitors 10, the combination of the manufacturing year and the manufacturing month of the power (amount) monitors 10, or only the sequence number in the embodiment. Further, it is also possible to perform the search one digit by one digit from the higher-order digit in the sequence number in the embodiment. In this manner, it is possible to select the desired power (amount) monitors 11, 12, 13 in a short time in the case in which there are a small number of power (amount) monitors 10.

Note that the search may be able to be performed two digits by two digits.

In a specific example of the method of searching a serial number, a serial number search start year is set to "2015", and a serial number search start month is set to "1" as illustrated in FIG. 8B, for example. In this manner, all the power (amount) monitors 10 that have been manufacturing since January 2015 are selected. The selected power (amount) monitors 10 are displayed on a list by the power (amount) monitor recognition tool 34 as illustrated in FIG. 8C. At this time, the CPU 33 turns on the display lamps 11Fc that are the lamps for the selected power (amount) monitors 10 in the power (amount) management system 1 according to the embodiment. In this manner, since the plurality of selected power (amount) monitors 10 turn on the alarm LED, for example, in the display lamps 11Fc, it is possible to check which of the power (amount) monitors 10 have been selected. Note that all the LEDs in the display lamps 11Fc may be turned on for example, when the lamp is turned on. In addition, the entire display unit 11Fa may be turned on.

Here, the following processing is performed in the method of searching the serial numbers according to the embodiment.

For example, whether or not there are power (amount) monitors 10 manufactured in 2015 is searched, and in a case in which there is no power (amount) monitors 10 manufactured in 2015, the search for the power (amount) monitors 10 manufactured in 2015 is completed. Then, whether or not there are power (amount) monitors 10 manufactured in 2016 is searched. In a case in which there are multiple power (amount) monitors 10 manufactured in 2016, reception is made for all the power (amount) monitors 10. That is, since it is only necessary to be able to ascertain that there are power (amount) monitors manufactured in 2016 even if the allowable amount of the list is reached or exceeded, the next search for whether or not there are power (amount) monitors 10 manufactured in 2016 is performed.

That is, lower-order search is not performed in a case in which no coincidence is obtained in the higher-order search in the embodiment. As a result, search efficiency is improved, and also, it is possible to quickly perform the search even of multiple power (amount) monitors 10 have been detected and connection has been established with the power (amount) monitors 10.

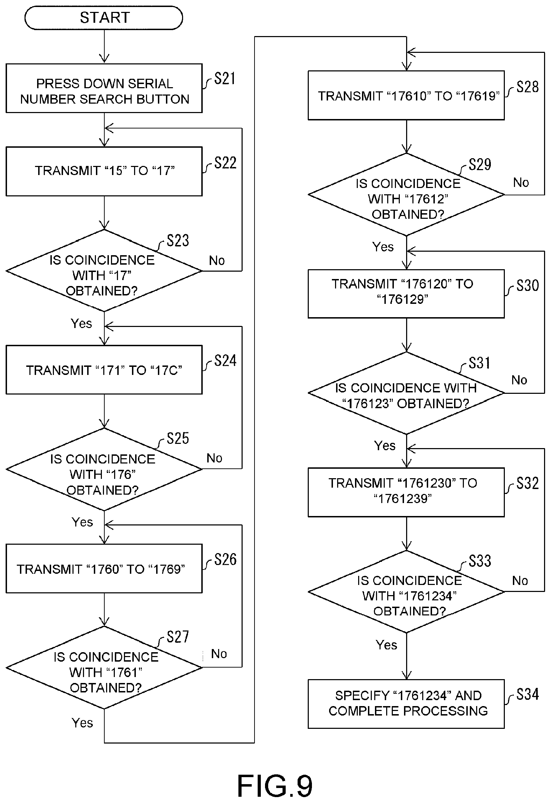

Next, a method of searching manufacturing numbers of specific power (amount) monitors 10 by the power (amount) monitor recognition tool 34 will be described with reference to FIG. 9. FIG. 9 is a flowchart illustrating a method of searching the manufacturing numbers of the power (amount) monitors 10 by the power (amount) monitor recognition tool 34.

The aforementioned method of searching the manufacturing numbers of the power (amount) monitors 11, 12, 13 according to the embodiment will be described in detail with reference to FIG. 9. Note that the following description will be given on the assumption that the power (amount) monitors 10 with the serial number of "1761234", for example, that is the manufacturing number are selected.

As illustrated in FIG. 9, the serial number search button 34b is pressed down first (S21). Subsequently, "15" to "17", for example, are transmitted (S22). The transmission indicates that the search is performed by setting the serial number search start year to "2015". As a result, it is determined whether or not coincidence with "17" (S23) is obtained, and if no coincidence with "17" is obtained, the processing returns to S22.

In a case in which the coincidence with "17" is obtained in S23, "171" to "17C" (S24). This means that the power (amount) monitors 10 with the serial number search start month from January 2017 to December 2017 are searched. That is, October is represented by "A", November is represented by "B", and December is represented by "C". In this manner, it is possible to represent the months of two digits with one digit. As a result, it is determined whether or not the coincidence with "176" is obtained (S25), and if no coincidence with "176" is obtained, the processing returns to S24.

In a case in which the coincidence with "176" is obtained in S25, "1760 to "1769" are transmitted (S26). This means that the power (amount) monitors 10 with the serial number search start month of June 2017 and with thousands place number of the sequence number are to be detected. As a result, it is determined whether or not coincidence with "1761" is obtained (S27), and if no coincidence with "1761" is obtained, the processing returns to S26.

In a case in which coincidence with "1761" is obtained in S27, "17610" to "17619" are transmitted (S28). This means that the power (amount) monitors 10 with the serial number search start month of June 2017 and with hundreds place number of the sequence number are to be detected. As a result, it is determined whether or not coincidence with "17612" is obtained (S29), and if no coincidence with "17612" is obtained, the processing returns to S28.

Similarly, a tens place number and a ones place number of the sequence number are searched (S30 to S33), power (amount) monitors 10 with the serial number, which is the manufacturing number, that coincides with "1761234" are finally specified, and the processing is completed (S34).

Note that the personal computer 30 can set at least a part of setting items for the power (amount) monitors 10 between the personal computer 30 and the specified power (amount) monitors 10 after the specification of the power (amount) monitors 10.

Incidentally, sequential numbers are applied for each mode of the power (amount) monitors 10 as the serial numbers that are the manufacturing numbers of the power (amount) monitors 10 in the power (amount) management system 1 in many cases. In this case, there is a possibility that a plurality of power (amount) monitors 10 of different models with the same serial numbers cannot be identified by the selection using only the serial numbers of the power (amount) monitors 10.

Thus, the desired power (amount) monitors 10 are selected by using model codes of the power (amount) monitors 10 in addition to the serial numbers in the power (amount) management system 1 according to the embodiment. In this manner, it is possible to identify the plurality of power (amount) monitors 10 of different models with the same serial numbers.

Note that the official models themselves may be used, and it is also possible to use abbreviations of the models by using the model codes. Use of the abbreviations has an advantage that it is possible to simplify the models as compared with the use of official models.

In addition, it is possible to employ the plurality of power (amount) monitors 10 of different modes in this manner.

In addition, it is possible to easily apply unit numbers that are management numbers, which have been applied in the power (amount) management system in the related art, in the power (amount) management system 1 according to the embodiment.

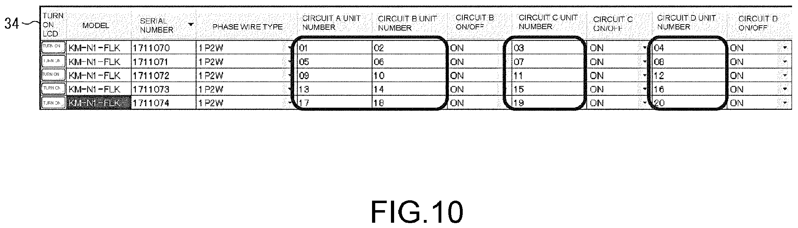

FIG. 10 is an enlarged view illustrating operations of assigning the unit numbers to the respective power (amount) monitors 10 by the power (amount) monitor recognition tool 34 of the personal computer 30 and illustrating a software screen of the power (amount) monitor recognition tool 34.

As illustrated in FIG. 10, it is possible to select all the power (amount) monitors 10 in the power (amount) management system 1 according to the embodiment.

As a result, it is possible to cause the selected power (amount) monitors 10 to be displayed in order and to automatically apply the unit numbers that are ascending sequential numbers, for example. The application of the unit numbers may be set by manual operations or can be automatically and collectively set. In addition, the application of the unit numbers can also be set by classifying the unit numbers for each of circuits A to D that section the multiple power (amount) monitors 10 as illustrated in FIG. 10.

In a case in which the aforementioned selection or the like of the power (amount) monitors 10 is completed, the mode is returned from the setting mode that is a mode in which the power (amount) monitors 10 are identified to the ordinary mode that is a mode in which the respective power (amount) monitors 10 transmit the power (amounts) values.

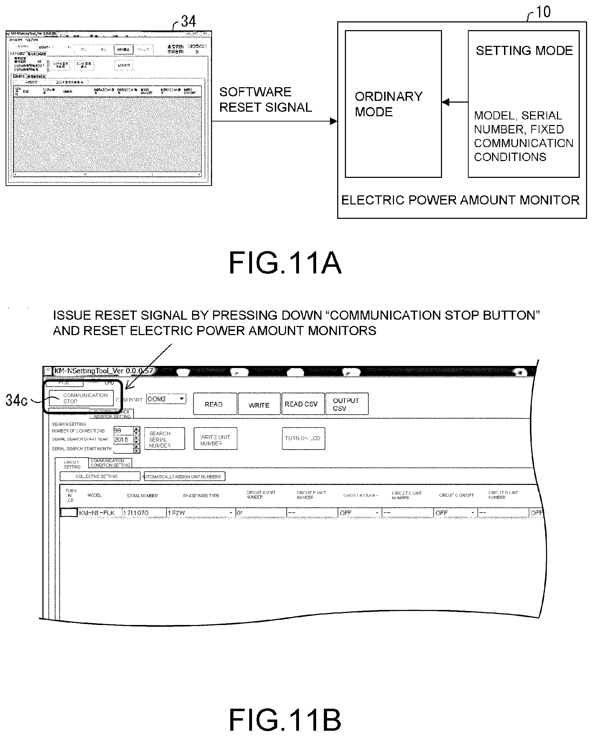

FIG. 11A is a diagram schematically illustrating operations of causing the power (amount) monitors 10 to transition from the setting mode to the ordinary mode by the power (amount) monitor recognition tool 34 of the personal computer 30 in the power (amount) management system 1. FIG. 11B is a partial enlarged view illustrating a software screen of the power (amount) monitor recognition tool 34.

In a case in which the respective power (amount) monitors 10 are made to transition from the setting mode to the ordinary mode as illustrated in FIG. 11B, the personal computer 30 presses down a communication stop button 34c on the software screen of the power (amount) monitor recognition tool 34, thereby transmitting the commands for causing the respective power (amount) monitors 11, 12, 13 to transmit from the setting mode to the ordinary mode, that is, reset signals to the respective power (amount) monitors 11, 12, 13. In this manner, the power (amount) monitors 10 are made to transition from the setting mode to the ordinary mode as illustrated in FIG. 11A. Thereafter, the power (amount) monitors 10 are transported to and installed at the respective measurement points.

In this manner, the power (amount) management system 1 according to the embodiment includes the plurality of power (amount) monitors 10 and the personal computer 30 that is the management device connected to the respective power (amount) monitors 10 for communication. The respective power (amount) monitors 10 include the ordinary mode that is the first mode in which at least the power (amounts) values are transmitted under the individual communication conditions and the setting mode that is the second mode in which the personal computer 30 is made to recognize the respective power (amount) monitors 10. The personal computer 30 includes the CPU 33 that is the control unit that transmits the commands for causing the respective power (amount) monitors 10 to transition from the ordinary mode to the setting mode by using all combinations of possible communication conditions of of the respective power (amount) monitors 10. The CPU 33 selects desired power (amount) monitors 10 by using the serial numbers that are the manufacturing numbers set in advance for the respective power (amount) monitors 10 and communicates with the selected power (amount) monitors.

As a result, the personal computer 30 transmits the commands for causing the respective power (amount) monitors 10 to transition from the ordinary mode to the setting mode by using the all combinations of the possible communication conditions of the respective power (amount) monitors 10. In this manner, the personal computer 30 can communicate with the respective power (amount) monitors 10.

In addition, the CPU 33 selects the desired power (amount) monitors 10 by using the manufacturing numbers set in advance for the respective power (amount) monitors 10 and communicates with the selected power (amount) monitors 10. Thereafter, it is possible to perform communication between the selected power (amount) monitors 10 and the personal computer 30. Note that since the manufacturing numbers are generally sequential numbers, the personal computer 30 can easily select the power (amount) monitors 10 with the manufacturing numbers in a range by designating the range of the manufacturing numbers for searching.

This means that it is possible to easily and individually communicate between the power (amount) monitors 10 and the personal computer 30 in a short time by using the manufacturing numbers set for the respective power (amount) monitors 10 without performing the manual recognition operations based on the management numbers, which have been performed in the related art.

Incidentally, although the respective power (amount) monitors 10 transmit at least the power (amounts) values under the individual communication conditions in the ordinary mode, the respective power (amount) monitors 10 and the personal computer 30 perform communication by using the manufacturing numbers set for the respective power (amount) monitors 10 in a special case. Thus, the respective power (amount) monitors 10 is provided with the setting mode in which the personal computer 30 is made to recognize the respective power (amount) monitors 10 as a mode that is different from the ordinary mode, and the communication between the respective power (amount) monitors 10 and the personal computer 30 is performed by using the manufacturing numbers in this setting mode.

As a result, it is possible to provide the power (amount) management system 1 capable of shortening the time required for the recognition operations of the respective power (amount) monitors 10 by the personal computer 30 in a case in which there are multiple power (amount) monitors 10 in the power (amount) management system 1 according to the embodiment.

In addition, the CPU 33 communicates with the power (amount) monitors 10 under the common communication conditions in a case in which the power (amount) monitors 10 are in the setting mode in the power (amount) management system 1 according to the embodiment. As a result, since it is possible to omit the time and efforts for individually communicating with the plurality of power (amount) monitors 10 by using the individual communication conditions, the personal computer 30 can communicate with the respective power (amount) monitors 10 in a short time.

In addition, the power (amount) monitor recognition tool 34 of the CPU 33 selects the desired power (amount) monitors 10 by using the model codes of the power (amount) monitors 10 in addition to the manufacturing numbers in the power (amount) management system 1 according to the embodiment.

In this manner, it is also possible to employ a plurality of power (amount) monitors 10 of different models. In addition, it becomes possible to identify the plurality of power (amount) monitors 10 of different models with the same manufacturing numbers.

Note that the official models themselves may be used, and it is also possible to use abbreviations of the models by using the model codes. Use of the abbreviations has an advantage that it is possible to simplify the models as compared with the use of official models.

In addition, the manufacturing number include the codes that represent manufacturing years and manufacturing months and sequence numbers of the power (amount) monitors 10, and the power (amount) monitor recognition tool 34 of the CPU 33 selects the corresponding power (amount) monitors 10 and causes the power (amount) monitors 10 to be displayed by respectively designating the model code, the manufacturing year, the manufacturing month, and the sequence number of the power (amount) monitors 10 in the power (amount) management system 1 according to the embodiment. As a result, it is possible to select the desired power (amount) monitors 10 in a short time in a case in which there are a small number of power (amount) monitors 10.

In addition, the power (amount) monitor recognition tool 34 of the CPU 33 applies unit numbers that are the management numbers to the selected power (amount) monitors 10 in the power (amount) management system 1 according to the embodiment. In this manner, it is possible to manage the power (amount) monitors 10 by using the unit numbers that are the management numbers which have been used in the related art.

In addition, the CPU 33 turns on the display lamps 11Fc that are the lamps for the selected power (amount) monitors 10 in the power (amount) management system 1 according to the embodiment. In this manner, since the plurality of selected power (amount) monitors 10 turn on the display lamps 11Fc, it is possible to check which of the power (amount) monitors 10 have been selected.

In addition, the CPU 33 can set at least a part of setting items for the power (amount) monitors 10 in the power (amount) management system 1 according to the embodiment. In this manner, it is possible to set at least the part of setting items for specific power (amount) monitors 10 after the specific power (amount) monitors 10 are identified. Therefore, it is possible to provide the convenient power (amount) management system 1.

In addition, the power (amount) monitor recognition tool 34 of the CPU 33 can transmit the commands for causing the power (amount) monitors 10 to transition from the setting mode to the ordinary mode in the power (amount) management system 1 according to the embodiment. In this manner, the respective power (amount) monitors 10 can transmit at least the power (amounts) values under the individual communication conditions in the ordinary mode after receiving the commands. In addition, if the unit numbers that are the management numbers have already been set in this case, the respective power (amount) monitors 10 can transmit at least the power (amounts) values to the personal computer 30 or the like under the individual communication conditions by using the management numbers in a manner similar to that in the related art.

### [Implementation example by software]

The control unit of the control block in the power (amount) management system 1 is realized by software using the CPU 33.

Specifically, the power (amount) management system 1 includes a CPU that executes commands of a program that is software for implementing the respective functions, a read only memory (ROM) or a storage device (these will be referred to as a "recording medium") in which the aforementioned program and various kinds of data are recorded in a computer- (or CPU-) readable manner, a random access memory (RAM) that develops the aforementioned program, and the like. In addition, the object according to an aspect of the present invention is achieved by the computer (or the CPU) reading the aforementioned program from the aforementioned recording medium and executing the program. As the aforementioned recording medium, a "non-transitory tangible medium", for example, a tape, a disc, a card, a semiconductor memory, a programmable logic circuit, or the like can be used. In addition, the aforementioned program may be supplied to the aforementioned computer via an arbitrary transmission medium (a communication network, a broadcasting wave, or the like) capable of transmitting the program. Note that the aforementioned program can be implemented in the form of data signals that realize the program by electronic transmission and are incorporated in carrier waves according to an aspect of the present invention.

### [Reference Signs List]

1 Power (amount) management system
10 Power (amount) monitor
11, 12, 13 Each power (amount) monitor
11Fc Display lamp
11i Communication unit
20 Communication interface
30 Personal computer (management device)
31 Keyboard
33 CPU
34 Power (amount) monitor recognition tool
34a Communication start button
34b Serial number search button
34c Communication stop button

## Claims

1. A power management system (1) comprising:
a plurality of power monitors (10, 11, 12, 13); and
a management device (30) that is connected to the respective power monitors (10, 11, 12, 13) for communication,
**characterized in that** the respective power monitors (10, 11, 12, 13) include a first mode in which at least the power value is transmitted under individual communication conditions, wherein the communication conditions at least include a communication rate, and a second mode in which the management device (30) is made to recognize the respective power monitors (10, 11, 12, 13), and
the management device (30) includes a control unit (11c) adapted to transmit commands for causing the respective power monitors (10, 11, 12, 13) to transition from the first mode to the second mode by using all combinations of possible communication conditions of the respective power monitors (10, 11, 12, 13), wherein a manufacturing management identifier is an identifier that is applied to the power monitor (10, 11, 12, 13) when the power monitor is manufactured, and the identifier is inputted in the management device (30) by a user in order to select the desired power monitor, wherein the second mode is a communication mode wherein the communication is performed under common communication conditions, that is, under fixed communication conditions for the plurality of power monitors (10, 11, 12, 13), so as to omit to individually communicate with the plurality of power monitors (10, 11, 12, 13) by using the individual communication conditions.

2. The power management system (1) according to claim 1, wherein the control unit (11c) is adapted to select the desired power monitor (10, 11, 12, 13) by using a model code of the power monitor (10, 11, 12, 13) in addition to the manufacturing management identifier.

3. The power management system (1) according to claim 2,
wherein the manufacturing management identifier includes a code that represents a manufacturing year and a manufacturing month and a sequence number of the power amount monitor (10, 11, 12, 13), and
the control unit (11c) is adapted to select the corresponding power monitor (10, 11, 12, 13) and to cause the power monitor (10, 11, 12, 13) to perform display by designating the model code, the manufacturing year, the manufacturing month, and the sequence number of the power monitor (10, 11, 12, 13).

4. The power management system (1) according to any one of claims 1 to 3, wherein the control unit (11c) is adapted to apply a management number to the selected power monitor (10, 11, 12, 13).

5. The power management system (1) according to any one of claims 1 to 4, wherein the control unit (11c) is adapted to turn on a lamp for the selected power monitor (10, 11, 12, 13).

6. The power management system (1) according to any one of claims 1 to 5, wherein the control unit (11c) is able to set at least a part of setting items for the power monitor (10, 11, 12, 13).

7. The power management system (1) according to any one of claims 1 to 6, wherein the control unit (11c) is able to transmit a command for causing the power monitor (10, 11, 12, 13) to transition from the second mode to the first mode.

## Patentansprüche

1. Strommengenverwaltungssystem (1), das Folgendes umfasst:
eine Vielzahl von Leistungsmonitoren (10, 11, 12, 13); und
eine Verwaltungsvorrichtung (30), die zur Kommunikation mit den jeweiligen Leistungsmonitoren (10, 11, 12, 13) verbunden ist,
**dadurch gekennzeichnet, dass** die jeweiligen Leistungsmonitore (10, 11, 12, 13) einen ersten Modus, in dem zumindest der Leistungswert unter individuellen Kommunikationsbedingungen übertragen wird, wobei die Kommunikationsbedingungen zumindest eine Kommunikationsrate umfassen, und einen zweiten Modus umfassen, in dem die Verwaltungsvorrichtung (30) dazu gebracht wird, die jeweiligen Leistungsmonitore (10, 11, 12, 13) zu erkennen, und
die Verwaltungsvorrichtung (30) eine Steuereinheit (11c) enthält, die angepasst ist, um Befehle zu übertragen, um zu bewirken, dass die jeweiligen Leistungsmonitore (10, 11, 12, 13) von dem ersten Modus in den zweiten Modus übergehen, indem alle Kombinationen möglicher Kommunikationsbedingungen der jeweiligen Leistungsmonitore (10, 11, 12, 13) verwendet werden, wobei eine Herstellungsmanagement-Kennung eine Kennung ist, die auf den Leistungsmonitor (10, 11, 12, 13) angewendet wird, wenn der Leistungsmonitor hergestellt wird, und die Kennung in die Verwaltungsvorrichtung (30) von einem Benutzer eingegeben wird, um den gewünschten Leistungsmonitor auszuwählen, wobei der zweite Modus ein Kommunikationsmodus ist, bei dem die Kommunikation unter gemeinsamen Kommunikationsbedingungen durchgeführt wird, d.h. unter festen Kommunikationsbedingungen für die Vielzahl von Leistungsmonitoren (10, 11, 12, 13), um eine individuelle Kommunikation mit der Vielzahl von Leistungsmonitoren (10, 11, 12, 13) unter Verwendung der individuellen Kommunikationsbedingungen zu vermeiden.

2. Strommengenverwaltungssystem (1) nach Anspruch 1, wobei die Steuereinheit (11c) so eingerichtet ist, dass sie den gewünschten Leistungsmonitor (10, 11, 12, 13) unter Verwendung eines Modellcodes des Leistungsmonitors (10, 11, 12, 13) zusätzlich zur Herstellungsmanagement-Kennung auswählt.

3. Strommengenverwaltungssystem (1) nach Anspruch 2,
wobei die Herstellungsmanagement-Kennung einen Code enthält, der ein Herstellungsjahr und einen Herstellungsmonat und eine laufende Nummer des Leistungsmengenmonitors (10, 11, 12, 13) darstellt, und
die Steuereinheit (11c) geeignet ist, den entsprechenden Leistungsmonitor (10, 11, 12, 13) auszuwählen und den Leistungsmonitor (10, 11, 12, 13) zu veranlassen, eine Anzeige durchzuführen, indem sie den Modellcode, das Herstellungsjahr, den Herstellungsmonat und die laufende Nummer des Leistungsmonitors (10, 11, 12, 13) angibt.

4. Strommengenverwaltungssystem (1) nach einem der Ansprüche 1 bis 3, wobei die Steuereinheit (11c) so ausgelegt ist, dass sie eine Verwaltungsnummer auf den ausgewählten Leistungsmonitor (10, 11, 12, 13) anwendet.

5. Strommengenverwaltungssystem (1) nach einem der Ansprüche 1 bis 4, wobei die Steuereinheit (11c) so ausgelegt ist, dass sie eine Lampe für den ausgewählten Leistungsmonitor (10, 11, 12, 13) einschaltet.

6. Strommengenverwaltungssystem (1) nach einem der Ansprüche 1 bis 5, wobei die Steuereinheit (11c) in der Lage ist, zumindest einen Teil der Einstellwerte für den Leistungsmonitor (10, 11, 12, 13) einzustellen.

7. Strommengenverwaltungssystem (1) nach einem der Ansprüche 1 bis 6, wobei die Steuereinheit (11c) in der Lage ist, einen Befehl zu übertragen, um den Leistungsmonitor (10, 11, 12, 13) zu veranlassen, vom zweiten Modus in den ersten Modus überzugehen.

## Revendications

1. Un système de gestion de la quantité de puissance (1) comprenant les éléments suivants
un grand nombre de moniteurs de performance (10, 11, 12, 13) ; et
un dispositif de gestion (30) connecté pour communiquer avec les moniteurs de performance (10, 11, 12, 13),
**caractérisé en ce que** les moniteurs de performance (10, 11, 12, 13) comprennent un premier mode dans lequel au moins la valeur de performance est transmise sous des conditions de communication individuelles , les conditions de communication comprenant au moins un débit de communication, et un deuxième mode dans lequel le dispositif de gestion (30) est amené à reconnaître les moniteurs de performance respectifs (10, 11, 12, 13), et
le dispositif de gestion (30) comprend une unité de commande (11c) adaptée pour transmettre des commandes afin d'amener les moniteurs de performance (10, 11, 12, 13) à passer du premier mode au deuxième mode en utilisant toutes les combinaisons de conditions de communication possibles des moniteurs de performance (10, 11, 12, 13), où est un identifiant de gestion de fabrication, qui est appliqué au moniteur de performance (10, 11, 12, 13) lorsque le moniteur de performance est fabriqué, et l'identifiant est entré dans le dispositif de gestion (30) par un utilisateur pour sélectionner le moniteur de performance souhaité, dans lequel le deuxième mode est un mode de communication dans lequel la communication est effectuée dans des conditions de communication communes, c'est-à-dire dans des conditions d'utilisation communes.c'est-à-dire sous des conditions de communication fixes pour la pluralité de moniteur de performance (10, 11, 12, 13) afin d'éviter une communication individuelle avec la pluralité de moniteurs de performance (10, 11, 12, 13) en utilisant les conditions de communication individuelles.

2. Le système de gestion de la quantité de puissance (1) selon la revendication 1, dans lequel l'unité de commande (11c) est agencée pour sélectionner le moniteur de performance (10, 11, 12, 13) souhaité en utilisant un code de modèle du moniteur de performance (10, 11, 12, 13) en plus de l'identifiant de gestion de fabrication.

3. Le système de gestion de la quantité de puissance (1) selon la revendication 2,
dans lequel l'identifiant de gestion de fabrication comprend un code représentant une année et un mois de fabrication et un numéro d'ordre du moniteur de performance (10, 11, 12, 13), et
l'unité de commande (11c) est adaptée pour sélectionner le moniteur de performance (10, 11, 12, 13) et pour faire en sorte que le moniteur de performance (10, 11, 12, 13) effectue une indication en spécifiant le code de modèle, l'année de fabrication, le mois de fabrication et le numéro d'ordre du moniteur de performance (10, 11, 12, 13).

4. Le système de gestion de la quantité de puissance (1) selon l'une quelconque des revendications 1 à 3, dans lequel l'unité de commande (11c) est adaptée pour appliquer un numéro de gestion au moniteur de performance sélectionné (10, 11, 12, 13).

5. Le système de gestion de la quantité de puissance (1) selon l'une quelconque des revendications 1 à 4, dans lequel l'unité de commande (11c) est adaptée pour allumer une lampe pour le moniteur de performance sélectionné (10, 11, 12, 13).

6. Le système de gestion de la quantité de puissance (1) selon l'une quelconque des revendications 1 à 5, dans lequel l'unité de commande (11c) est capable d'ajuster au moins une partie des valeurs de réglage pour le moniteur de performance (10, 11, 12, 13).

7. Le système de gestion de la quantité de puissance (1) selon l'une quelconque des revendications 1 à 6, dans lequel l'unité de commande (11c) est apte à transmettre une commande pour que le moniteur de performance (10, 11, 12, 13) passe du deuxième mode au premier mode.
